# EUROPEAN PATENT APPLICATION

(11) **EP 2 804 217 A1**
(43) Date of publication of application: **19.11.2014**
(21) Application number: 14152205.2
(22) Date of filing: 22.01.2014
(51) Int. Cl.: H01L 31/02, H01L 31/0224, H01L 27/142

(54) **Contact structure for solar cell**

(30) Priority: 14.05.2013 US 201361823138 P; 14.01.2014 US 201414154299
(71) Applicant: Samsung SDI Co., Ltd., Yongin-si, Gyeonggi-do (KR)
(72) Inventor: Yang, Jung-Yup, Gyeonggi-do (KR); Nam, Jung-Gyu, Gyeonggi-do (KR)
(74) Representative: Mounteney, Simon James

(57) **Abstract**

A solar cell (100) includes a substrate (110), a first electrode layer (120) formed on the substrate (110), an intermediate layer (133) formed on the first electrode layer (120), and a light-absorbing layer (140) formed on the intermediate layer (133). A contact wire (160) is attached to the intermediate layer (133) in an area, where the intermediate layer (133) is not covered by the light-absorbing layer (140). The thickness of the intermediate layer (133) is reduced in the wire contact area (131) to improve the series resistance of the composite electrode layer (120) and (133).

## Description

### BACKGROUND

### 1. Field

An aspect of the present invention relates to a solar cell.

### 2. Description of the Related Art

As demands on energy increase, demands on solar cells for converting sunlight energy into electrical energy have recently been increased. The solar cells are clean energy sources that produce electricity from the sun as an infinite energy source. The solar cells have come into the spotlight as new growth engine with a high industrial growth rate every year.

A copper-indium-gallium-(di)selenide (CIGS) solar cell is a solar cell that can be implemented as a thin film and does not use Si. Thus, it is expected that the CIGS solar cell will play an important role in spread of sunlight energy by lowering production cost of solar cells. Further, it is known that since the CIGS solar cell is thermally stable, a decrease in efficiency hardly exists as time elapses. Therefore, various studies have been conducted to increase power-generating capacity of the CIGS solar cell.

### SUMMARY

Embodiments provide a solar cell having a new structure.

Embodiments also provide a solar cell having improved power-generation efficiency.

The present invention provides a solar cell as defined in all of claims 1 to 9 and a process for preparing said solar cell as defined in claims 10 to 14.

According to an aspect of the present invention, there is provided a solar cell, including: a substrate; a first electrode layer formed on the substrate; an intermediate layer formed on the first electrode; and a wire connected to the intermediate layer. The wire may preferably come in direct contact with the intermediate layer. In the present invention the intermediate layer comprises regions of differing thickness. This does not encompass intermediate layers where the difference in thickness is one achieved in the course of the normal production of the intermediate layer. The difference in thickness is one that is achieved by an additional process feature that is not present in a standard process for production of such an intermediate layer. The present invention requires that there regions of differing thickness achieved either by building up one region in respect of the others or removing part of one region in respect of the others. The present invention does not encompass variations passively achieved by the standard production of the intermediate layer.

In an embodiment of the present invention the intermediate layer may preferably be continuously disposed on the first electrode. In an embodiment of the present invention the term "continuously" means that there are no gaps exposing the first electrode through the intermediate layer.

The intermediate layer may preferably be configured to include first to third regions. The wire may preferably be formed in the first region, and any one or more of a light-absorbing layer and a second electrode layer may preferably be formed in the third region.

The light-absorbing layer and the second electrode layer may preferably be sequentially formed in at least portion of the third region, and only the second electrode layer may preferably be formed in another portion of the third region.

The second region may preferably be provided between the first and third regions, and the intermediate layer may be exposed to the outside of the solar cell. In this embodiment, "exposed to the outside" does not mean "open air", it simply means not covered by any of the features recited. For example, when the solar cell is modularized, the second region may preferably be encompassed by a sealant to stop the entry of oxygen or water.

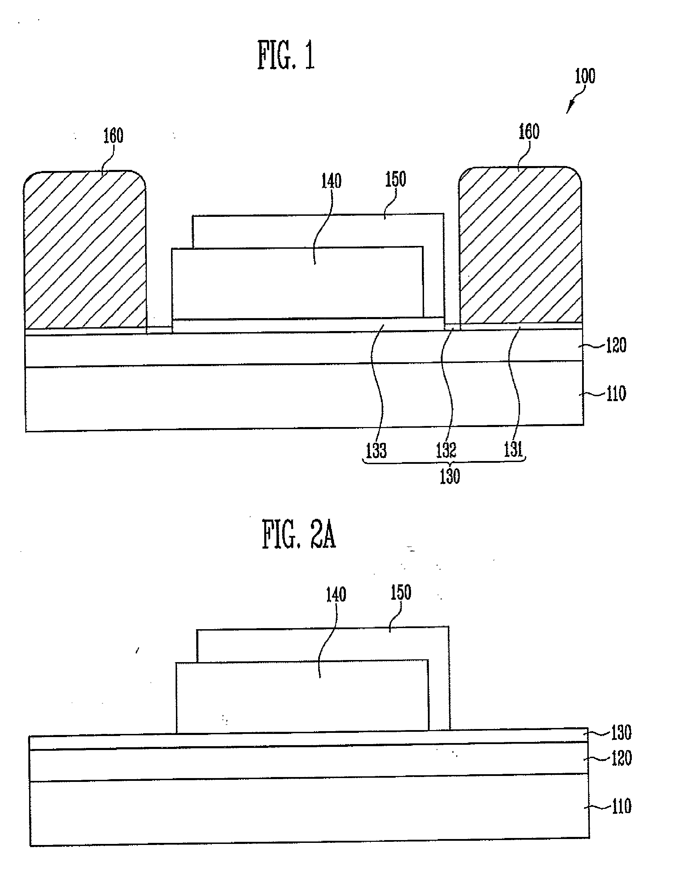

The thickness of the first region may preferably be formed thinner than that of the third region. In an embodiment of the present invention the thickness of the third region corresponds to the thickness of the intermediate layer immediately after the layer has been produced (see, for example, Figure 2A). In an embodiment of the present invention the thickness of the first region is achieved by carrying out an etching process on a portion of the initially formed intermediate layer.

The thickness of the first region may preferably be 0.05nm to 50nm, preferably 0.07nm to 40nm, more preferably 0.1 to 30nm and most preferably 10nm to 20nm.

The first electrode layer may preferably include Mo, and the intermediate layer may preferably be an alloy layer that may preferably include MoSe_{X} (X is a natural number).

According to another aspect of the present invention, there is provided a method of manufacturing a solar cell, including: forming a first electrode layer on a substrate; forming an intermediate layer on the first electrode layer; and forming first to third regions having different thicknesses by removing a portion of the intermediate layer. The method may preferably further include attaching a wire to the first region. The method of the present invention preferably incorporates the feature discussed above in respect of the product of the present invention.

The wire may preferably be attached to the first region, using any one or more of conductive tape, soldering, ultrasonic soldering and Ag glue.

The removing of the portion of the intermediate layer may preferably be performed by any one of a mechanical method, a laser method, a plasma method and a wet etching method.

As described above, according to the present invention, it is possible to provide a solar cell having a new structure.

Further, it is possible to provide a solar cell having improved power-generation efficiency.

### BRIEF DESCRIPTION OF THE DRAWINGS

The accompanying drawings, together with the specification, illustrate embodiments of the present invention, and, together with the description, serve to explain the principles of the present invention.
FIG. 1 is a sectional view of a solar cell according to an embodiment of the present invention.
FIG. 2A is a sectional view schematically illustrating a state before a third region is provided in FIG. 1.
FIG. 2B is a sectional view schematically illustrating a state after the third region is provided in FIG. 2A.
FIG. 3 is a sectional view of a solar cell according to another embodiment of the present invention.
FIG. 4 is a flowchart illustrating a method of manufacturing a solar cell according to an embodiment of the present invention.
FIG. 5 is a graph illustrating resistances according to thicknesses of a first electrode layer.

### DETAILED DESCRIPTION

In the following detailed description, only certain embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. In addition, when an element is referred to as being "on" another element, it can be directly on the another element or be indirectly on the another element with one or more intervening elements interposed therebetween. Also, when an element is referred to as being "connected to" another element, it can be directly connected to the another element or be indirectly connected to the another element with one or more intervening elements interposed therebetween. Hereinafter, like reference numerals refer to like elements.

FIG. 1 is a sectional view of a solar cell according to an embodiment of the present invention.

With reference to FIG. 1 as a highly preferred embodiment of the present invention, the solar cell 100 according to this embodiment includes a substrate 110, a first electrode layer 120 formed on the substrate 110, an intermediate layer 130 formed on the first electrode layer 120, and a wire 160 connected to the intermediate layer 130. For example, the wire 160 may preferably be directly attached to the intermediate layer 130. A light-absorbing layer or a portion of a second electrode layer 150 may preferably be formed on the intermediate layer 130. In an embodiment of the present invention the light-absorbing layer may preferably be contacted on the top and at least one side by the second electrode.

The substrate 110 may preferably be a glass substrate, ceramic substrate, metal substrate, polymer substrate, etc. For example, the substrate 110 may preferably be a glass substrate including alkali elements such as sodium (Na), potassium (K) and cesium (Cs) therein. Preferably, the substrate 110 may preferably be a sodalime glass substrate. The alkali elements included in the substrate 110 are diffused into the light-absorbing layer 140 during a process of manufacturing the solar cell 100, so as to increase the concentration of electrons in the light-absorbing layer 140, thereby improving photoelectric conversion efficiency.

The first electrode layer 120 may preferably be made of a conductor such as metal. For example, the first electrode layer 120 may preferably be made of a material having excellent safety at a high temperature and high electrical conductivity. The first electrode layer 120 may preferably be formed using a material having an excellent junction property with the substrate 110 and the light-absorbing layer 140, respectively provided on and beneath of the first electrode layer 120. Preferably, the first electrode layer 120 may preferably be made of molybdenum (Mo).

The intermediate layer 130 is formed on an upper portion of the first electrode 120 and preferably at the interface where the light-absorbing layer 140 and the first electrode layer 120 contact each other so as to protect a surface of the first electrode layer 120. The intermediate layer 130 may preferably be formed by performing a selenization process. For example, the intermediate layer 130 may preferably be formed by forming the light-absorbing layer 140 on the upper portion of the first electrode layer 120 and then allowing the first electrode layer 120 to react with selenium (Se) through the selenization process. In this case, the selenium (Se) may directly react with the surface of the first electrode layer 120, or may be diffused downward from an upper surface of the light-absorbing layer 140 so as to react with the surface of the first electrode layer 120, thereby forming the intermediate layer 130. For example, in a case where the first electrode layer 120 is made of molybdenum (Mo), the intermediate layer may be an alloy layer 130 that may be a selenized molybdenum compound (MoSeₓ) (here, x is a natural number).

The light-absorbing layer 140 is a layer that absorbs light so that electric charges are formed therein. The light-absorbing layer 140 may preferably be made of a compound semiconductor such as CIS, CGS or CIGS (here, C denotes copper (Cu), I denotes indium (In), G denotes gallium, and S denotes one or more of sulfur (S) and selenium (Se)). The light-absorbing layer 140 may preferably act as a p-type semiconductor.

The second electrode layer 150 is a conductive layer, and may preferably act as an n-type semiconductor. For example, the second electrode layer 150 may preferably be made of transparent conductive oxide (TCO). Preferably, the second electrode layer 150 may preferably be made of zinc oxide (ZnO).

Although not shown in this figure, a buffer layer may preferably be further formed between the light-absorbing layer 140 and the second electrode layer 150. The light-absorbing layer 140 formed beneath the buffer layer acts as the p-type semiconductor, and the second electrode layer 150 formed on the buffer layer acts as the n-type semiconductor, so that a p-n junction can be formed between the light-absorbing layer 140 and the second electrode layer 150. In this case, the buffer layer has a band gap of a middle level between the light-absorbing layer 140 and the second electrode layer 150, so that a satisfactory junction can be formed between the light-absorbing layer 140 and the second electrode layer 150. In an embodiment of the present invention the buffer layer may contact the top and at least one side of the light-absorbing layer and at least two inner surfaces of the second electrode. In an embodiment of the present invention the buffer layer may contact the intermediate layer at an intersection of the light absorbing layer and the second electrode layer.

In the solar cell 100 according to this embodiment, the intermediate layer 130 may preferably be configured to include first to third regions 131, 132 and 133. A wire 160 may preferably be provided in the first region 131, and any one or more of the light-absorbing layer 140 and the second electrode layer 150 may preferably be provided in the third region 133. In this case, the second region 132 may preferably allow the first and third regions 131 and 133 to be spaced apart from each other. At least one of the first to third regions 131, 132 and 133 may preferably be provided to have a thickness different from that of the others.

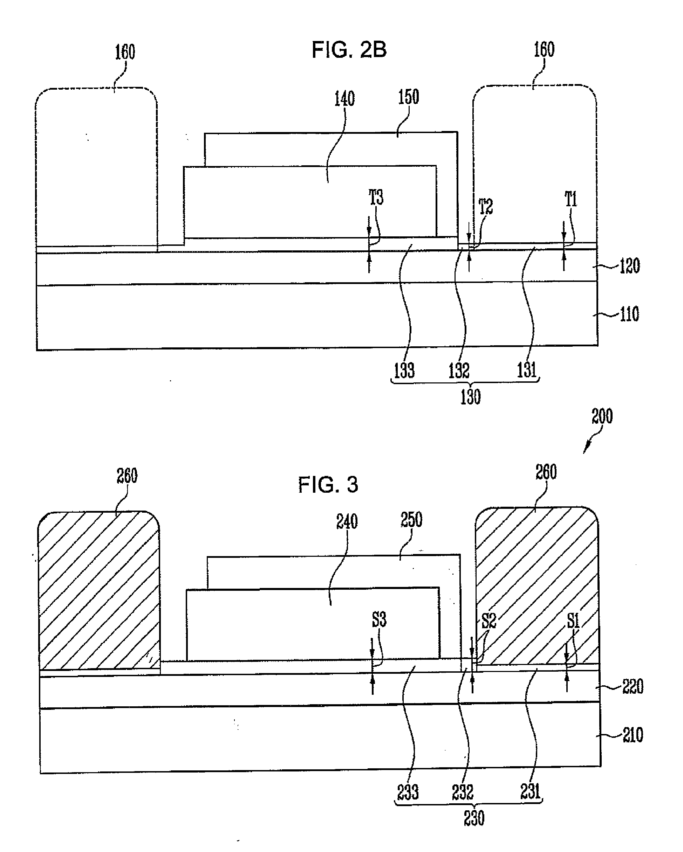

FIG. 2A is a sectional view schematically illustrating a state before a third region is provided in FIG. 1. FIG. 2B is a sectional view schematically illustrating a state after the third region is provided in FIG. 2A.

Referring to FIGS. 2A and 2B, the intermediate layer 130 is formed on the surface of the first electrode layer 120. In this case, the light-absorbing layer 140 or the second electrode layer 150 may preferably be formed on a portion of the intermediate layer 130. Alternatively, both the light-absorbing layer 140 and the second electrode layer 150 are not formed on another portion of the intermediate layer 130, but the intermediate layer 130 may be exposed, i.e. not covered by any of the light absorbing layer, the second electrode or the wire. The wire 160 may preferably serve as a passage through which current generated in the solar cell 100 is transferred to the outside of the solar cell 100. The wire 160 may preferably be made of a conductor such as metal.

The intermediate layer 130 formed on the first electrode layer 120 may preferably be provided to have an approximately similar thickness. Subsequently, a portion of the intermediate layer 130 is removed, and the wire 160 is formed at the portion having the intermediate layer 130 removed therefrom, so that the intermediate layer 130 can be divided into the first to third regions 131, 132 and 133.

The first region 131 in the intermediate layer 130 is a portion at which the wire 160 is attached to the intermediate layer 130, and a portion of the first region 131 may preferably be removed through etching. For example, the etching may preferably be performed by any one of a mechanical method, a layer method, a plasma method and a wet etching method. The thickness T1 of the first region 131 may preferably be formed thinner than that T3 of the third region 133, and the thickness T2 of the second region 132 may preferably be formed similar to that T3 of the third region 133.

Typically, the entire intermediate layer is removed from the portion at which the wire is attached to the intermediate layer, using a knife, etc., and the first electrode layer and the wire come in direct contact with each other. On the other hand, the process of removing the intermediate layer is necessarily performed several times in order to remove the entire intermediate layer, and an additional cleaning process, etc. are necessarily performed in order to remove a remaining intermediate layer. As such, a plurality of processes are necessarily performed to remove the entire intermediate layer. Since it takes a long period of time to perform the processes, process efficiency is lowered. In a case where the entire intermediate layer is removed from the first electrode layer, the wire contacts a portion of the first electrode layer, but a portion of the first electrode is exposed as it is. Therefore, moisture or the like is penetrated into the first electrode layer, thereby lowering the electrical efficiency of the solar cell. In a case where the wire comes in direct contact with the first electrode layer, the contact portion is pulled out in a thermal cycling test (TC test) due to the difference in thermal expansion coefficient between metal forming the wire and metal forming the first electrode layer. On the other hand, since the intermediate layer may optionally be a semiconductor layer, the intermediate layer acts as a resistor in the flow of current between the first electrode layer and the wire. Therefore, in a case where the wire is provided while maintaining the intermediate layer as it is, the electrical efficiency of the solar cell is lowered.

In the solar cell according to this embodiment, the process efficiency can be improved by simplifying the aforementioned process of removing the intermediate layer. Further, the thickness of the intermediate layer is controlled, thereby optimizing the flow of current between the first electrode layer and the wire, and the surface of the first electrode layer is protected, thereby improving the efficiency of the solar cell.

The wire may preferably be connected to the first region 131, and the thickness T1 of the first region 131 may preferably be 0.05nm to 50nm, preferably 0.07nm to 40nm, more preferably 0.1 to 30nm and most preferably 10nm to 20nm. In a case where the thickness T1 of the first region 131 is less than 0.5nm, preferably 0.1nm, a plurality of processes are necessarily performed to remove the first region 131 to less than 0.0.05nm, and therefore, the productivity of the solar cell 100 may be lowered. Further, the thickness of the first region 131 is too thin, and therefore, moisture or the like may be penetrated into the first electrode layer 120. In a case where the thickness of the first region 131 exceeds 50nm, preferably, 30nm, the thickness of the first region 131 is too thick, and therefore, the flow of current between the first electrode layer 120 and the wire 160 may not be smooth. Preferably, the thickness of the first region 131 may preferably be 15nm. In a case where the thickness of the first region 131 is 15nm, it is possible to prevent the moisture or the like from being penetrated into the first electrode layer 120 and to improve the efficiency of the flow of current between the first electrode layer 120 and the wire 160 at optimum conditions. Further, it is possible to simplify the process of removing the intermediate layer 130, thereby optimizing the productivity and electrical characteristic of the solar cell 100.

In an embodiment of the present invention the third region is of thickness 100nm to 300nm, optionally, 150nm to 250nm and optionally 175nm to 225nm.

The wire 160 may preferably be made of any one selected from the group consisting of Pb, Sn, Cu, Al, Ag, Au, Pt, Ni, Co, Ta and Ti. For example, the wire 160 may preferably be attached to the first region 131 in the intermediate layer 130, using any one or more of soldering, ultrasonic soldering, ultrasonic welding, Ag glue and conductive tape. Preferably, the wire 160 may preferably be attached to the first region 131 in the intermediate layer 130 using the ultrasonic soldering. In a case where the wire 160 is attached to the first region 131 of the intermediate layer 130 using the ultrasonic soldering, a portion of solder may preferably pass through the first region 131 and reach the first electrode layer 120 by means of ultrasonic energy, and thus the first region 131 in the intermediate layer 130 can have the lowest resistance.

The second region 132 may preferably be provided between the first and third regions 131 and 133. The second region 132 may preferably be removed together with the first region 131 so as to have a thickness similar to that of the first region 131. The second region 132 may preferably be formed on the first electrode layer 120 so as to protect the first electrode layer 120 from the penetration of moisture. The light-absorbing layer 140 and the second electrode layer 150 may preferably be sequentially formed in at least a portion of the third region 133, and only the second electrode layer 150 may preferably be formed in another portion of the third region 133.

Hereinafter, another embodiment of the present invention will be described with reference to FIG. 3. Contents of this embodiment, except the following contents, are similar to those of the embodiment described with reference to FIGS. 1 to 2B, and therefore, their detailed descriptions will be omitted.

FIG. 3 is a sectional view of a solar cell according to another embodiment of the present invention.

Referring to FIG. 3, the solar cell 200 according to this embodiment may preferably include a substrate 210, a first electrode layer 220 formed on the substrate 210, an intermediate layer 230 formed on the first electrode layer 220, and a wire 260 directly connected to the intermediate layer 230.

The intermediate layer 230 may preferably be configured to include first to third regions 231, 232 and 233. The wire 260 may preferably be connected to the first region 231, and a light-absorbing layer 240 and a second layer 250 may preferably be formed on the third region 233. Alternatively, the light-absorbing layer 240 may optionally be omitted, and the second electrode layer 250 may preferably be formed on the third region 233. The second region 232 may preferably be formed between the first and third regions 231 and 233, so as to allow the first and third regions 231 and 233 to be spaced apart from each other.

In this embodiment, the first region 231 may preferably be formed to have a thickness different from that of the second and third regions 232 and 233. For example, only an upper layer of the first region 231 may preferably be removed in the intermediate layer 230, and the thickness S1 of the first region 231 may preferably be formed thinner than that S2 of the second region 232 and that S3 of the third region 233. The thickness S2 of the second region 232 may preferably be formed approximately identical to that S3 of the third region 233.

The first region 231 is a portion at which the wire 260 is connected thereto, and the thickness S1 of the first region 231 may preferably be formed to 0.1 to 30nm by considering the flow of current between the wire 260 and the first electrode layer 220, the adhesion between the first region 231 and the wire 260, etc. In a case where the thickness S1 of the first region 231 is less than 0.05nm, preferably 0.1nm, the time required to remove the first region 231 to less than 0.1nm is increased. Further, the wire may come off, during the TC test, due to lowering of the adhesion between the first region 231 and the wire 260, caused by a difference in thermal expansion coefficient between materials respectively constituting the first region 231 and the wire 260. In a case where the thickness S1 of the first region 231 exceeds 50nm, preferably 30nm, the resistance between the wire 260 and the first electrode layer 220 is increased, and therefore, the current efficiency of the solar cell may be lowered.

In the solar cell 200 according to this embodiment, the thickness S2 of the second region 232 may preferably be formed similar to that S3 of the third region 233. Thus, the process of removing the intermediate layer 230 can be omitted in the second region 232, thereby improving the process efficiency of the solar cell. Further, only the intermediate layer 230 can be formed approximately on the first electrode layer 220 in the second region 232, and thus the thickness S2 of the second region 232 can be maintained thick. Accordingly, it is possible to improve the ability of protection against penetration of moisture into the first electrode layer, etc.

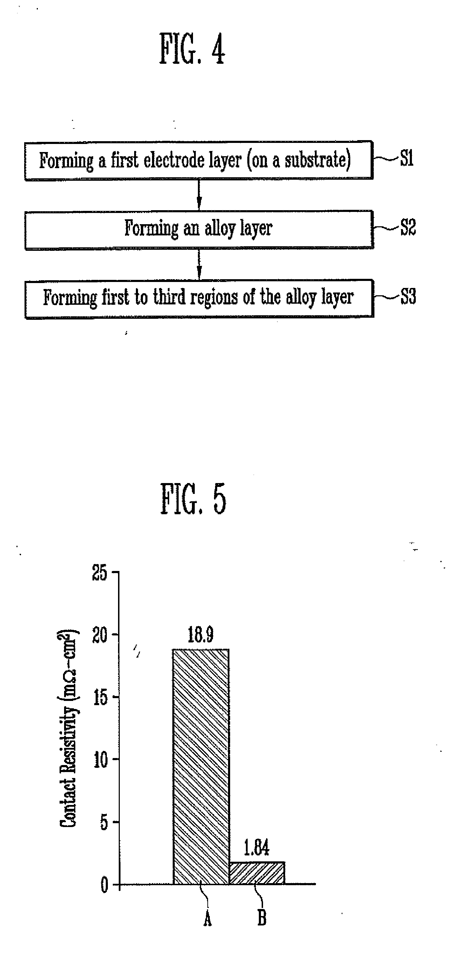

FIG. 4 is a flowchart illustrating a method of manufacturing a solar cell according to an embodiment of the present invention.

Referring to FIG. 4, the method according to this embodiment may preferably include forming a first electrode layer on a substrate (S1), forming an intermediate layer on the first electrode layer (S2), and forming first to third regions having different thicknesses by removing a portion of the intermediate layer (S3). The method may preferably further include attaching a wire to the first region after the forming of the first to third regions (S3). The thickness of the first region may preferably be formed thinner than that of the third region.

The method may preferably further include forming a light-absorbing layer on a portion of the first electrode layer before the forming the intermediate layer on the first electrode layer (S2). The forming of the intermediate layer on the first electrode layer (S3) may preferably be performed through a selenization process. For example, the substrate may preferably include glass, and the first electrode layer may preferably include Mo. In this case, the intermediate layer formed through the selenization process may preferably include MoSe_{X} (X is a natural number).

In the forming of the first to third regions (S3), the first region may preferably be formed by removing a portion of the intermediate layer. The removing of the portion of the intermediate layer may preferably be performed by any one of a mechanical method, a laser method, a plasma method and a wet etching method. The thickness of the first region may preferably be 0.1 to 30nm. The intermediate layer in the second region can prevent moisture from being penetrated into the first electrode layer.

The wire may preferably serve as a passage through which current generated in the solar cell is discharged to the outside of the solar cell. For example, the wire may preferably be made of any one or more selected from the group consisting of Pb, Sn, Cu, Al, Ag, Au, Pt, Ni, Co, Ta and Ti. The wire may preferably be attached to the first region, using any one or more of conductive tape, soldering, ultrasonic soldering, ultrasonic welding and Ag glue. Preferably, the wire may be attached to the first region, using the ultrasonic soldering. In this case, the thickness of the first region is 0.05nm to 50nm, preferably 0.1 to 30nm, which is thin, and thus a portion of solder may preferably pass through the first region and reach the first electrode layer by means of ultrasonic energy. Thus, the electrical energy between the wire and the first electrode layer is easily performed by the solder, so that resistance is decreased, thereby improving the mobility of current.

Hereinafter, embodiments of the present invention and a comparative example are described. However, the following embodiments are merely preferred embodiments of the present invention, and the scope of the present invention is not limited by the following embodiments.

### EXAMPLES

A first electrode made of Mo was formed on a substrate using glass, and a light-absorbing layer made of CIG (e.g., CuGa/In, CuInGa or the like) was formed on the first electrode. Then, a selenization process was performed on the substrate having the first electrode and the light-absorbing layer. After the selenization process was performed, Se was diffused into the light-absorbing layer, and an intermediate layer made of MoSe₂ was formed on a surface on the first electrode layer. Alternatively, the light-absorbing layer made of CIGSeS may preferably be formed by performing a sulfurization process in order to obtain high voltage. The thickness of a first region to which a wire was attached at a portion where the MoSe₂ was exposed was changed as described in the following Table 1. In this case, the wire was made of conductive tape in which a conductive layer is configured with metal particles such as Ni or Ag, and the thickness of the first region was mechanically removed using a knife. The conductive tape was attached to the first region, and the resistance of the MoSe₂ was then measured.

**Table 1**

| | | | | | |
|---|---|---|---|---|---|
| Thickness of MoSe₂ | 200nm | 30nm | 20nm | 0.1nm | 0nm |
| Resistance (mΩcm²) | 18.9 | 1.843 | 1.84 | 1.81 | 25 |
| TC test | OK | OK | OK | OK | NG |

Table 1 shows resistances with respect to thicknesses of portions at which the wire is attached to the first region in the MoSe₂ and results of a thermal cycling (TC) test. In the TC test, OK means a case where the wire is well attached without coming off from the intermediate layer during the TC test, and NG means a case where the wire comes off from the intermediate layer during the TC test.

In Table 1, the portion at which the thickness of the MoSe₂ is 200nm is a portion at which the selenization process is performed and the MoSe₂ is not removed. In a case where the thickness of the MoSe₂ is 200 to 0.1nm, the adhesion between the wire and the MoSe₂ is performed. Hence, the adhesion between metals is not performed, but the adhesion between the MoSe₂ layer and the wire as metal. Thus, it can be seen that the result is OK in the TC test because the lowering of the adhesion, caused by a difference in (metal) thermal expansion coefficient between metals in the TC test, is minimized. On the other hand, the thickness of the MoSe₂ is too thick at the portion where the thickness of the MoSe₂ is 200nm, and therefore, the resistance between the wire and the first electrode layer is increased. Accordingly, it can be seen that the current efficiency is considerably lowered.

The portion at which the thickness of the MoSe₂ is 0nm is a portion at which the MoSe₂ is entirely removed from the attachment portion of the wire. The wire comes in direct contact with the first electrode layer, and thus the resistance is very low. On the other hand, it can be seen that the wire (Cu) is easily separated from the first electrode layer (Mo), during the TC test, by the difference in thermal expansion coefficient between Mo forming the first electrode layer and Cu forming the wire. The process of removing the MoSe₂ using the knife was performed several times in order to remove the entire MoSe₂, and the cleaning process was additionally performed using chromic acid, laser or the like in order to remove the entire remaining MoSe₂. In order to remove the entire MoSe₂, the removing process was performed plural times, and the manufacturing process was taken for a long period of time. Further, it can be seen that the result of the TC test is NG. Since a portion of the first electrode layer is exposed as it is, it can be seen that moisture or the like is penetrated into the first electrode layer.

When the thicknesses of MoSe are respectively 30nm, 20nm and 0.1nm, it can be seen that all the results of the TC test are OK, and the resistances are respectively 1.843, 1.84 and 1.81, which are approximately similar. That is, it can be seen that the resistances in the thickness of 0.1 to 30nm are approximately similar, and the adhesion between the MoSe and the wire is similar in the thickness of 0.1 to 30nm. In addition, the MoSe₂ is removed so that the thicknesses of the MoSe are respectively 30nm, 20nm and 0.1nm, and a portion of the MoSe₂ remains, so that the process of removing the MoSe₂ can be efficiently performed.

FIG. 5 is a graph illustrating resistances according to thicknesses of a first electrode layer.

Specifically, the contact resistances in a case A where the thickness of the MoSe₂ is 200nm and a case B where the thickness of the MoSe₂ is 30nm are shown in Table 1. Referring to FIG. 5, it can be seen that the resistance in the case A where the wire is attached without removing the MoSe₂ is approximately 10 times or more greater than that in the case B where the wire is attached after the MoSe₂ is removed and only 30nm is left.

When the wire (Pb) was attached to the MoSe₂ having the thickness of 30nm, a case where the attachment was performed using the conductive tape and a case where the attachment was performed using the ultrasonic soldering were compared in the following Table 2.

**Table 2**

| Wire attaching method | Conductive tape | Ultrasonic soldering |
|---|---|---|
| Thickness of MoSe | 30nm | 30nm |
| Resistance (mΩcm²) | 1.843 | 1.56 |
| TC test | OK | OK |

Referring to Table 2, when the thickness of the MoSe is 30nm, it can be seen that both the results in the case where the wire is attached to the MoSe using the conductive tape and the case where the wire is attached to the MoSe using the ultrasonic soldering are OK in the TC test. On the other hand, it can be seen that the resistance in the case where the wire is attached to the MoSe using the ultrasonic soldering is lower than that in the case where the wire is attached to the MoSe. This is because a portion of solder is penetrated into the MoSe by ultrasonic energy during the ultrasonic soldering, and the flow of current is more efficiently performed by the penetrated solder.

While the present invention has been described in connection with certain embodiments, it is to be understood that the invention is not limited to the disclosed embodiments, but, on the contrary, is intended to cover various modifications and equivalent arrangements included within the scope of the appended claims, and equivalents thereof.

## Claims

1. A solar cell, including: a substrate; a first electrode layer formed on the substrate; an intermediate layer formed on the first electrode; and a wire connected to the intermediate layer, wherein the intermediate layer comprises regions of differing thickness.

2. The solar cell of claim 1, wherein the thinnest region of the intermediate layer is connected to the wire.

3. The solar cell of claim 1 or claim 2, wherein the intermediate layer is configured to include first to third regions and the first region is connected to the wire and any one or more of a light-absorbing layer and a second electrode layer are formed on the third region.

4. The solar cell of claim 3, where the first region is of thickness 0.05nm to 50nm, optionally, 0.07nm to 40nm, optionally 0.1 to 30nm and optionally 10nm to 20nm.

5. The solar cell of any of claims 1 to 4, wherein the intermediate layer comprises molybdenum and selenium.

6. The solar cell of claim 5, wherein the intermediate layer comprises a selenized molybdenum compound MoSeₓ, where, x is a natural number.

7. The solar cell of any of claims 3 to 6, wherein the second region is formed between the first and third regions.

8. The solar cell of any of claims 3 to 7, wherein the second region is the same thickness as either the first region or the third region.

9. The solar cell of any of claims 1 to 8 wherein the intermediate layer is continuously disposed on the first electrode.

10. A process for producing a solar cell as claimed in any of claims 1 to 9 comprising the steps of: forming a first electrode layer on a substrate, forming an intermediate layer on the first electrode layer, and forming first to third regions having different thicknesses by removing a portion of the intermediate layer in a first region.

11. The process of claim 10, further including attaching a wire to the first region.

12. The process of claim 11, wherein the wire is attached to the first region, using any one or more of conductive tape, soldering, ultrasonic soldering and Ag glue, optionally ultrasonic soldering.

13. The process of any of claims 10 to 12, wherein the difference thickness between the first and third regions is achieved by selectively etching a portion of intermediate layer to form the first region.

14. The process of any of claims 10 to 13, wherein removing of the portion of the intermediate layer is performed by any one of a mechanical method, a laser method, a plasma method and a wet etching method.
